# EUROPEAN PATENT APPLICATION

(11) **EP 1 065 729 A1**
(43) Date of publication of application: **03.01.2001**
(21) Application number: 99900328.8
(22) Date of filing: 18.01.1999
(51) Int. Cl.: H01L 29/74

(54) **COMPRESSION BONDED SEMICONDUCTOR DEVICE**

(71) Applicant: MITSUBISHI DENKI KABUSHIKI KAISHA, Tokyo 100-8310 (JP)
(72) Inventor: TOKUNOH, Futoshi, Mitsubishi Denki K.K., Tokyo 100-8310 (JP)
(74) Representative: Sajda, Wolf E., Dipl.-Phys.
(86) International application number: PCT/JP99/00119
(87) International publication number: WO 00/42663

(57) **Abstract**

To provide a compression bonded type semiconductor device capable of suppressing contact resistance of a power feeding path from an external gate electrode to an external cathode electrode, the device comprises a gate electrode 22a formed at the outer peripheral part of a gate electrode 22, a cathode electrode 22b formed at the inner part of the gate electrode 22, a cathode distortion buffer disk 23 and an external cathode electrode 24 disposed on the cathode electrode 22b, an elastic body 31, an annular insulator 33 and a press-contact auxiliary block 32 provided sequentially in contact with the external cathode electrode 24 between the external cathode electrode 24 and the gate electrode 22 and an external gate terminal 30 disposed so as to have a protrusion 30a whose one side contacts with the press-contact auxiliary block 32 and whose other side abuts to the gate electrode 22.

## Description

### TECHNICAL FIELD

The present invention relates to a compression bonded type semiconductor device such as GCT (Gate Commutated Turn-off) thyristor.

### BACKGROUND OF THE INVENTION

Hitherto, although a GTO (Gate Turn-OFF) thyristor has been widely used as a device applicable to large capacity power electronics, it has required a snubber circuit and it has been difficult to suppress the increase of snubber loss caused by the increase of its operating voltage. However, a GCT (Gate Commutated Turn-off) thyristor (hereinafter referred to simply as GCT) from which such snubber circuit is eliminated has realized the performance of 6000 A of the maximum breaking current and less than or equal to 3 µs of turn-off storage time and has accelerated the increase of the capacity and speed.

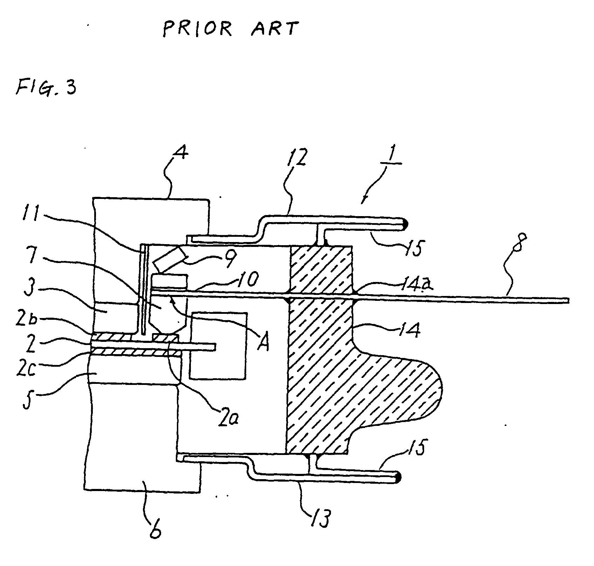

FIG. 3 is a section view showing the structure of a prior art compression bonded type semiconductor device, e.g., a GCT described in Japanese Patent Laid-Open No. Hei.8-330572(1996). In the figure, the reference numeral (1) denotes the GCT, (2) a semiconductor substrate, wherein an aluminum gate electrode 2a is formed at the outer peripheral part on the surface of the semiconductor substrate 2, a cathode electrode 2b is formed at the inside of the gate electrode 2a, and an anode electrode 2c is formed on the back of the gate electrode 2a, (3 and 4) a cathode distortion buffer disk and an external cathode electrode mounted one after another on the side of the cathode electrode 2b on the surface of the semiconductor substrate 2, (5 and 6) an anode distortion buffer disk and an external anode electrode mounted one after another on the side of the anode electrode 2c, (7) a ring gate electrode which is made of iron or nickel alloy and contacts with the gate electrode 2a of the semiconductor substrate 2,(8)a ring-shaped external gate terminal which is made of iron or nickel alloy and is electrically connected with the ring gate electrode 7, though it is not fixed thereto, (9) an elastic body such as a disk spring which presses the ring gate electrode 7 to the gate electrode 2a together with the external gate terminal 8 via an annular insulator 10, (11) an insulator for insulating the ring gate electrode 7 from the cathode distortion buffer disk 3 and the external cathode electrode 4, (12) a first flange secured to the external cathode electrode 4, (13) a second flange secured to the external anode electrode 6, and (14) an insulating cylinder which is made of ceramics or the like and is divided into upper and lower parts. The outer periphery of the external gate terminal 8 protrudes out of the side of the insulating cylinder 14 and is hermetically secured to a divisional part 14a by soldering and an end portion 15 secured to the insulating cylinder 14 by soldering is hermetically secured to the first and second flanges 12 and 13 by arc welding. Thus, the GCT 1 has the closed structure and the inside thereof is replaced by inert gas.

Next, the operation of the GCT 1 will be explained. Current is flown toward the external cathode electrode 4 from the external gate terminal 8 in turning on the GCT 1. The gradient of rise of the gate current at this time is generally set at 1000 A/µs or more in operating the GCT 1 without current limiting reactor and the turn-on spreading speed of the GCT 1 must be increased. While current is flown toward the external gate terminal 8 from the external cathode electrode 4 in turning it off, the current must be fed with the gradient of several thousands A/µs to commutate current equivalent to the main current of the GCT 1 to the gate at about 1 µs in order to operate it without a snubber circuit which aids the turn-off. Contact resistance of a current feeding path from the external gate terminal 8 to the external cathode electrode 4 must be minimized in order to feed such large current instantly.

While the cathode electrode 2b of the semiconductor substrate 2, the cathode distortion buffer disk 3 and the external cathode electrode 4 are pressed by a large force of several hundreds kg/cm² from the outside of the GCT 1, the gate electrode 2a of the semiconductor substrate 2, the ring gate electrode 7 and the external gate terminal 8 are pressed only by the elastic body 9 because the elastic body 9 is disposed at the peripheral part of the external cathode electrode 4. Due to that, the pressure at the part A where the external gate terminal 8 contacts with the ring gate electrode 7 becomes several kg/cm² and there has been a case where contact resistance sufficient for feeding the large power as described above instantly cannot be obtained.

Because the prior art GCT 1 has been constructed as described above, it has had the following problems.

That is, there has been a case where the external gate terminal 8 causes waviness in the circumferential direction at the contact part A of the inner peripheral part of the external gate terminal 8 and the ring gate electrode 7 by strain caused by thermal residual stress in soldering the external gate terminal 8 and the divisional part 14a of the insulating cylinder 14. However, because the external gate terminal 8 is pressed only by the elastic body 9, the pressure at the contact part A has been several kg/cm² and the waviness could not be corrected. Therefore, there has been a problem that the contact resistance of the contact part A is greater than desired contact resistance, i.e., the contact resistance of the feeding path from the external gate terminal 8 to the external cathode electrode 4 becomes large. As a result, it has become a factor of inhibiting the power feeding capability of the gate by lacking the gradient of the inverse direction gate current in turning off the GCT 1 for example.

The abnormality of the contact caused by the waviness has caused a problem that the contact resistance fluctuates within the plane of the ring-shaped external gate terminal 8. As a result, there has been a case where the power feeding capability of the gate drops partially, thus inviting an extreme drop of the turn-off capability.

There has been another problem that because iron or nickel alloy has been used for the external gate terminal 8 from the readiness of soldering with ceramics which is the material of the insulating cylinder 14, it abnormally generates heat by locally receiving electromagnetic induction by the magnetic field of the external circuit in operating at high frequency, thus influencing to the characteristics of the semiconductor substrate 2.

### DISCLOSURE OF THE INVENTION

The present invention has been devised in order to solve the above-mentioned problems and its primary object is to provide a compression bonded type semiconductor device which is capable of suppressing contact resistance of a current feeding path from an external gate terminal to an external cathode electrode, from increasing.

Another object of the invention is to provide a compression bonded type semiconductor device which is capable of suppressing fluctuation of contact resistance within the plane of the external gate terminal caused by waviness produced in the circumferential direction of the external gate terminal, from occurring at the part where the inner peripheral part of the external gate terminal contacts with a ring gate electrode.

A still other object of the invention is to provide a compression bonded type semiconductor device which is capable of suppressing the external gate terminal from abnormally generating heat by locally receiving electromagnetic induction by the magnetic field of the external circuit in operating at high frequency.

In the present invention, a gate electrode and a cathode electrode are formed on the surface of a semiconductor substrate and an anode electrode is formed on the back thereof. An external cathode electrode is disposed to be compression bondable to the cathode electrode and an external anode electrode is disposed to be compression bondable to the anode electrode. Then, there are provided an insulating cylinder containing the semiconductor substrate and an external gate terminal whose outer peripheral part protrudes out of the side of the insulating cylinder and is fixed to the insulating cylinder and which has a protrusion which is formed at the inner peripheral part and which abuts to the gate electrode. The external gate terminal is pressed to the gate electrode by an elastic body. In case the external gate terminal on which the protrusion which abuts to the gate electrode as described above is formed is provided and is pressed to the gate electrode by the elastic body, the external gate terminal contacts directly to the gate electrode and contact resistance which otherwise exists between the external gate terminal and the ring gate electrode in the prior art may be eliminated. Accordingly, it becomes possible to suppress the contact resistance of the feeding path from the external gate terminal to the external cathode electrode from increasing, and to improve the power feeding capability of the gate.

Further, in the present invention, a ring-shaped press-contact auxiliary block may be provided between the protrusion of the external gate terminal and the elastic body. In case the ring-shaped press-contact auxiliary block is provided between the protrusion of the external gate terminal and the elastic body as described above, it becomes possible to reduce the fluctuation of press-contact force at the part where the external gate terminal contacts with the gate electrode. Thus, it becomes possible to suppress the fluctuation of the contact resistance within the plane of the external gate terminal, from occurring due to waviness occurring at the inner peripheral part of the external gate terminal, by the strain caused by thermal residual stress in soldering the external gate terminal with the insulating cylinder.

Furthermore, in the present invention, the protrusion which abuts to the gate electrode may be formed in a body with the external gate terminal. In case the protrusion which abuts to the gate electrode is formed in a body with the external gate terminal, the external gate terminal directly contacts with the gate electrode, the external gate terminal contacts directly to the gate electrode and contact resistance which otherwise exists between the external gate terminal and the ring gate electrode in the prior art may be eliminated. Accordingly, it becomes possible to suppress the contact resistance of the feeding path from the external gate terminal to the external cathode electrode from increasing.

Still further, in the present invention, the protrusion which abuts to the gate electrode may be formed into a shape of a ring. In case the protrusion which abuts to the gate electrode is ring-shaped, the press-contact force at the part where the external gate terminal contacts with the gate electrode may be increased by about several tens of times as compared to the prior art. Thus, it becomes possible to obtain contact resistance sufficient for feeding a large power instantly, by correcting the waviness which otherwise occurs at the inner peripheral part of the external gate terminal due to the strain caused by the thermal residual stress in soldering the external gate terminal with the insulating cylinder.

Further, in the present invention, the member of the external gate terminal may be a non-magnetic member. In case the member of the external gate terminal is a non-magnetic member, it becomes possible to suppress the external gate terminal from generating heat abnormally by locally receiving electromagnetic induction by the magnetic field of the external circuit in operating at high frequency.

Furthermore, in the present invention, there is provided a compression bonded type semiconductor device comprising a disk-like semiconductor substrate having a gate electrode formed at the outer peripheral portion on the surface thereof, a cathode electrode formed inside of the gate electrode and an anode electrode formed on the back thereof; an external cathode electrode having a first flange and disposed to be compression bondable to the cathode electrode via a cathode distortion buffer disk; an external anode electrode having a second flange and disposed to be compression bondable to the anode electrode via an anode distortion buffer disk; an insulating cylinder containing the semiconductor substrate, cathode distortion buffer disk and anode strain buffer plate and secured to each end portion secured to the first and second flanges; an external gate terminal formed of a ring-shaped plate which is secured to the insulating cylinder, whose outer peripheral part protrudes out of the side of the insulating cylinder and is fixed to the insulating cylinder and which has a protrusion which is formed at the inner peripheral part thereof and which abuts to the gate electrode; an elastic body which presses the external gate terminal to the gate electrode; and an insulator for electrically insulating the inner peripheral part of the external gate terminal from the external cathode electrode. In case the external gate terminal formed of the ring-shaped plate having the protrusion which abuts to the gate electrode is provided and is pressed to the gate electrode by the elastic body, the external gate terminal contacts directly to the gate electrode and contact resistance which otherwise exists between the external gate terminal and the ring gate electrode in the prior art may be eliminated. Therefore, it becomes possible to suppress the contact resistance of the power feeding path from the external gate terminal to the external cathode electrode from increasing, and to improve the power feeding capability of the gate.

The foregoing and other objects, features, aspects and advantages of the present invention will become more apparent from the following detailed description of the present invention when taken in conjunction with the accompanying drawings.

### BRIEF DESCRIPTION OF THE DRAWINGS

FIG. 1 is a section view showing the structure of a compression bonded type semiconductor device according to a first embodiment of the invention;
FIG. 2 is a section view showing the structure of a compression bonded type semiconductor device according to a second embodiment of the invention; and
FIG. 3 is a section view showing the structure of a prior art compression bonded type semiconductor device.

### BEST MODE FOR CARRYING OUT THE INVENTION

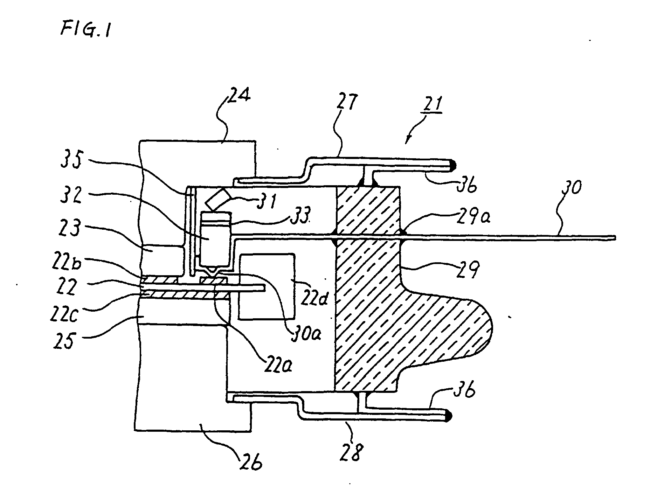

FIG. 1 is a section view showing the structure of a compression bonded type semiconductor device, e.g., a GCT, according to a first embodiment of the present invention. In FIG. 1, the reference numeral (21) denotes the GCT, (22) a disk-like semiconductor substrate, wherein an aluminum gate electrode 22a is formed at the peripheral part of the surface of the gate electrode 22, a cathode electrode 22b is formed at the inside of the gate electrode 22a, and an anode electrode 22c is formed on the back of the gate electrode 22a, (23 and 24) a cathode distortion buffer disk made of molybdenum and an external cathode electrode made of copper mounted one after another on the side of the cathode electrode 22b on the surface of the gate electrode 22,(25 and 26) an anode distortion buffer disk made of molybdenum and an external anode electrode made of copper mounted one after another on the side of the anode electrode 22c, (27) a first flange made of iron, nickel or the like and is secured to the external cathode electrode 24,(28) a second flange made of iron, nickel or the like and is secured to the external anode electrode 26, (29) an insulating cylinder which is made of ceramics or the like and is divided into upper and lower parts at the divisional part 29a,(30) a ring-shaped external gate terminal which is made of non-magnetic ring-shaped plate composed of a material which receives no electromagnetic induction such as copper, molybdenum, tungsten or their alloy, e.g., phosphor bronze, as a main component and whose outer periphery protrudes out of the side of the insulating cylinder 29 and is hermetically secured to a divisional part 29a by soldering. A ring-shaped protrusion 30a which abuts to the gate electrode 22a is formed at the inner peripheral section and an edge portion of the protrusion 30a abutting to the gate electrode 22a has a ring-shaped flat portion of about 0.5 mm, (31) an elastic body such as a disk spring or a wave spring which presses the external gate terminal 30 to the gate electrode 22a via a press-contact auxiliary block 32 described later, (32) the press-contact auxiliary block which is made of a material such as ring-shaped molybdenum which has rigidity and whose thermal expansion ratio is close to that of silicon and which is disposed between the elastic body 31 and the protrusion 30a of the external gate terminal 30 to electrically insulate the elastic body 31 and the press-contact auxiliary block 32 by the ring-shaped insulator 33, (35) an insulator which is made of an insulating sheet such as Teflon or polyimide and which is provided between the inner peripheral part of the external gate terminal 30 and the external cathode electrode 24 to electrically insulate the inner peripheral part of the external gate terminal 30 from the external cathode electrode 24, (36) an edge portion which is made of iron, nickel or the like and whose one end is hermetically secured to the insulating cylinder 29 and the other end is hermetically secured to the first flange 27 or the second flange 28. Thus, the GCT 21 has the closed structure and the inside thereof is replaced by inert gas.

Next, the operation of the GCT 21 will be explained. Current is flown toward the external cathode electrode 24 from the external gate terminal 30 in turning on the GCT 21. The gradient of rise of the gate current at this time is set at 1000 A/µs or more in general in operating the GCT 21 without current limiting reactor for example and the turn-on spreading speed of the GCT 21 must be increased. While current is flown toward the external gate terminal 30 from the external cathode electrode 24 in turning it off, the current must be fed with the gradient of several thousands A/µs to commutate current equivalent to the main current of the GCT 21 to the gate at about 1 µs in order to operate it without a snubber circuit which aids the turn-off. Contact resistance of a current feeding path from the external gate terminal 30 to the external cathode electrode 24 must be minimized in order to feed such large current instantly.

According to the first embodiment, while the external gate terminal 30 abuts to the gate electrode 22a, it is provided with the protrusion 30a. This configuration allows the external gate terminal 30 to directly contact with the gate electrode 22a and the contact resistance interposed between the external gate terminal 8 and the ring gate electrode 7 in the prior is to be eliminated, so that it becomes possible to suppress the contact resistance of the feeding path from the external gate terminal 30 to the external cathode electrode 24 from increasing, and to improve the power feeding capability of the gate.

Further, the ring-shaped press-contact auxiliary block 32 is provided between the protrusion 30a of the external gate terminal 30 and the elastic body 31. This configuration lessens the fluctuation of press-contact force at the part where the external gate terminal 30 made of the thin plate contacts with the gate electrode 22a. Thus, it becomes possible to suppress the fluctuation of the contact resistance within the plane of the external gate terminal 30 from occurring due to waviness occurring at the inner peripheral part of the external gate terminal 30 by the strain caused by thermal residual stress in soldering the external gate terminal 30 with the insulating cylinder 29.

Still more, the protrusion 30a is formed into a ring-shaped and the edge portion of the protrusion 30a contacting with the gate electrode 22a is a ring-shaped flat portion of about 0.5 mm. It allows the press-contact force at the part where the external gate terminal 30 contacts with the gate electrode 22a to be increased by about several tens of times as compared to the prior art. Thus, it becomes possible to obtain contact resistance sufficient for feeding a large power instantly by correcting the waviness which otherwise occurs at the inner peripheral part of the external gate terminal 30 due to the strain caused by the thermal residual stress in soldering the external gate terminal 30 with the insulating cylinder 29.

Still more, the member of the external gate terminal 30 is a non-magnetic member. It allows the external gate terminal 30 to be suppressed from generating heat abnormally by locally receiving electromagnetic induction by the magnetic field of the external circuit in operating at high frequency.

It is noted that the GCT 21 shown in the first embodiment is built up by assembling the insulator 35, the elastic body 31, the ring-shaped insulator 33 and the press-contact auxiliary block 32 while placing at the lower side the external cathode electrode 24 to which the first flange 27 is secured, a semi-finished item in which the external gate terminal 30 and the edge portion 36 are secured to the insulating cylinder 29 in another step is positioned, and then the first flange 27 is secured to the edge portion 36 secured to the insulating cylinder 29 at desired position. It allows the external cathode electrode 24 and the external gate terminal 30 to be positioned. Therefore, it becomes possible to position the gate electrode 22, the external gate terminal 30 and the external cathode electrode 24 accurately from each other because the a mold portion 22d provided at the outer peripheral portion of the gate electrode 22 engages with the external gate terminal 30.

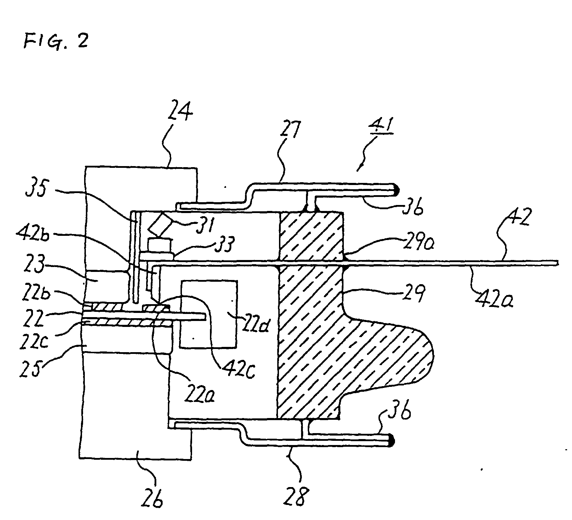

Next, a compression bonded type semiconductor device according to another embodiment of the present invention will be explained by using FIG. 2.

FIG. 2 is a section view showing the structure of a GCT according to the second embodiment of the present invention. The same reference numerals with those used in FIG. 1 denote the same or corresponding components. What is different in FIG. 2 from FIG. 1 is only the point in that the press-contact auxiliary block 32 is eliminated and the structure of the external gate terminal 30 is changed. That is, the reference numeral (42) denotes a ring-shaped external gate terminal formed of a non-magnetic ring-shaped plate made of a material which receives no electromagnetic induction such as copper, molybdenum, tungsten or their alloy, e.g., phosphor bronze, as the main material. The outer periphery 42a of the external gate terminal 42 protrudes out of the side of the insulating cylinder 29 and is hermetically secured to a divisional part 29a by soldering, and a ring-shaped protrusion 42c which abuts to the gate electrode 22a is formed at the inner periphery part in a body with a ring-shaped gate portion 42b formed of a non-magnetic ring-shaped plate made of a material soldered at inner peripheral part and which receives no electromagnetic induction such as copper, molybdenum, tungsten or their alloy, e.g., phosphor bronze, as the main material. The edge portion of the protrusion 42c abutting to the gate electrode 22a has a ring-shaped flat portion of about 0.5 mm. It is noted that the reference numeral (41) denotes a GCT.

According to the second embodiment, the ring-shaped protrusion 42c which abuts to the gate electrode 22a is formed in a body with the ring-shaped gate portion 42b soldered to the inner peripheral part of the external gate terminal 42. Such configuration allows the external gate terminal 42 to directly contact with the gate electrode 22a and contact resistance which otherwise exists between the external gate terminal 8 and the ring gate electrode 7 in the prior art to be eliminated. Therefore, it becomes possible to suppress the contact resistance of the power feeding path from the external gate terminal 42 to the external cathode electrode 24 from increasing, and to improve the power feeding capability of the gate.

It is noted that although one in which the gate electrode is formed at the outer peripheral part of the surface of the semiconductor substrate has been explained as one example of the gate structure of the GCT in the first and second embodiments, one in which the gate electrode is formed at the intermediate part of the surface of the semiconductor substrate may be adopted and brings about the same operational effects.

Further, although the GCT has been explained in the first and second embodiments, the present invention is also applicable to a compression bonded type semiconductor device having a main electrode and a control electrode such as a compression bonded type GTO or compression bonded type IGBT, bringing about the same operational effects.

Although the present invention has been described and illustrated in detail, it is clearly understood that the same is by way of illustration and example only and is not to be taken by way of limitation, the spirit and scope of the present invention being limited only by the terms of the appended claims.

### INDUSTRIAL APPLICABILITY

As described above, the inventive compression bonded type semiconductor device is suitable for quickly turning on/off large current of the main circuit by the gate control. For instance, it is suitable for BTB (Bus Tie Breaker) and SVG (Static Var Generator) as an application to electric power, for driving a large capacity inverter for paper or steel making rolling mill as an application to industrial use, for a ground transformer station as an application to rail railways and for a high voltage large capacity switch, etc.

## Claims

1. A compression bonded type semiconductor device, comprising:
a semiconductor substrate having a gate electrode and a cathode electrode formed on the surface thereof and an anode electrode formed on the back thereof;
an external cathode electrode disposed to be compression bondable to said cathode electrode;
an external anode electrode disposed to be compression bondable to said anode electrode;
an insulating cylinder containing said semiconductor substrate;
an external gate terminal whose outer peripheral part protrudes out of the side of said insulating cylinder and is fixed to said insulating cylinder and which has a protrusion which is formed at the inner peripheral part thereof and which abuts to said gate electrode; and
an elastic body which presses said external gate terminal to said gate electrode.

2. The compression bonded type semiconductor device according to Claim 1, wherein a ring-shaped press-contact auxiliary block is provided between said protrusion of said external gate terminal and said elastic body.

3. The compression bonded type semiconductor device according to Claim 2, wherein said protrusion is ring-shaped.

4. The compression bonded type semiconductor device according to Claim 3, wherein the member of said external gate terminal is a non-magnetic member.

5. The compression bonded type semiconductor device according to Claim 1, wherein said protrusion is formed in a body with said external gate terminal.

6. The compression bonded type semiconductor device according to Claim 5, wherein said protrusion is ring-shaped.

7. The compression bonded type semiconductor device according to Claim 6, wherein the member of said external gate terminal is a non-magnetic member.

8. A compression bonded type semiconductor device, comprising:
a disk-like semiconductor substrate having a gate electrode formed at the outer peripheral portion on the surface thereof, a cathode electrode formed inside of said gate electrode and an anode electrode formed on the back thereof;
an external cathode electrode having a first flange and disposed to be compression bondable to said cathode electrode via a cathode distortion buffer disk;
an external anode electrode having a second flange and disposed to be compression bondable to said anode electrode via an anode distortion buffer disk;
an insulating cylinder containing said semiconductor substrate; cathode distortion buffer disk and anode strain buffer plate and secured to each end portion secured to said first and second flanges;
an external gate terminal formed of a ring-shaped plate whose outer peripheral part protrudes out of the side of said insulating cylinder and is hermetically fixed to said insulating cylinder and which has a protrusion which is formed at the inner peripheral part thereof and which abuts with said gate electrode;
an elastic body which presses said external gate terminal to said gate electrode; and
an insulator for electrically insulating the inner peripheral part of said external gate terminal from said external cathode electrode.

9. The compression bonded type semiconductor device according to Claim 8, wherein a ring-shaped press-contact auxiliary block is provided between the protrusion of said external gate terminal and said elastic body.

10. The compression bonded type semiconductor device according to Claim 8, wherein said protrusion is formed in a body with said external gate terminal.
